# EUROPÄISCHE PATENTSCHRIFT

(11) **EP 1 772 966 B1**
(45) Veröffentlichungstag und Bekanntmachung des Hinweises auf die Patenterteilung: **20.08.2014**
(21) Anmeldenummer: 06019534.4
(22) Anmeldetag: 19.09.2006
(51) Int. Cl.: H03K 19/177

(54) **Schaltungsarchitektur für eine integrierte Schaltung**
Circuit architecture for an integrated circuit
Architecture de circuit pour un circuit integré

(30) Priorität: 07.10.2005 DE 102005048525
(43) Veröffentlichungstag der Anmeldung: 11.04.2007
(73) Patentinhaber: Micronas GmbH, 79108 Freiburg i. Br. (DE)
(72) Erfinder: Umbach, Gert, Dr., 79194 Gundgelfingen (DE)
(74) Vertreter: Koch Müller Patentanwaltsgesellschaft mbH

(56) Entgegenhaltungen:
- WO-A-03/105345
- US-A- 4 758 985

## Beschreibung

Die Erfindung bezieht sich auf eine Schaltungsarchitektur für eine integrierte Schaltung, insbesondere auf eine Anordnung von Recheneinheiten, Auswahleinheiten und Steuereinheiten in einer solchen.

Da die Verwendung von integrierten Schaltungen in allen Bereichen der Elektronik seit Jahren stark zunimmt, werden seitens der Hersteller und auch auf Grund der Anforderungen der Anwender große Anstrengungen unternommen, um eine möglichst effiziente Realisierung von integrierten Schaltungen in einer möglichst kurzen Zeit zu erreichen. Die Elektronikindustrie wird dabei beständig von der Notwendigkeit angetrieben, die Leistung zu steigern, die Kosten zu reduzieren und die Merkmale der zur Verfügung gestellten integrierten Schaltungen zu verbessern. Weitere Anforderungen bestehen unter anderem darin, die angebotenen, beispielsweise als integrierte Schaltungen ausgeführten Schaltungsarchitekturen hinsichtlich Flächenbedarf, Leistungsaufnahme und Verlustleistung zu optimieren.

Vielen dieser Notwendigkeiten wird durch die Verwendung von neueren, schnelleren und billigeren Technologien entsprochen. Diese neuen Technologien ermöglichen es, dass eine größere Anzahl von Funktionen und Merkmalen auf einem einzelnen Stück Silizium (einer integrierten Schaltung) zusammengefasst werden können. Funktionen, die zuvor nur auf separaten Chips zur Verfügung standen, können heute in einem einzelnen, in einem Chip integrierten System angeboten werden. Auf Grund der Komplexität und der hohen Spezialisierung in den verschiedenen Einsatzgebieten integrierter Schaltungen werden dabei heute zunehmend anwendungsspezifische integrierte Schaltungen eingesetzt.

Diese Gruppe der anwendungsspezifische integrierten Schaltungen kann dabei weiter unterteilt werden in anwenderprogrammierbare Bauelemente und in für spezifische Anwendungen gefertigte Bauelemente, wobei letztere zwar hoch spezialisiert sein können, jedoch für die Ausführung von fest vorgegebenen Funktionen gefertigt werden und durch den Anwender nicht konfigurierbar sind.

In vielen Bereichen besteht jedoch gerade die Anforderung, integrierte Schaltungen zur Verfügung zu stellen, deren Architektur dem Anwender die gewünschte Flexibilität bietet, schnell auf geänderte oder neue Anforderungen zu reagieren. Bei diesen auch als anwenderprogrammierbare Bauelemente bezeichneten integrierten Schaltungen handelt es sich um universelle Elemente, deren Fertigung vom Hersteller völlig standardisiert vorgenommen wird und die erst durch eine vom Anwender vorzunehmende Programmierung oder Konfigurierung auf ihre endgültige Funktion festgelegt werden. Siehe dazu G. Umbach, 1966, Kaiserslautern, Dissertation "Optimierung makrozellenbasierter Sea-of-Gates Architekturen für die Kommunikationstechnik".

Ein repräsentatives Beispiel für den Einsatzbereich solcher durch den Anwender konfigurierbarer Bauelemente ist die Automobilindustrie, in der immer kürzere Produktentwicklungszyklen gefordert werden. So kommen zum Beispiel in einem Oberklasse-Automobil schon heute mehr als 70 Steuerungssysteme zum Einsatz. Entsprechend steigt der Anteil der Elektronik und Software auf über 30% in der Wertschöpfungskette. Durch die zunehmende Komplexität und die Zahl der Aufgaben eines elektronischen Systems werden jedoch auch die Entwurfsaufgaben zunehmend anspruchsvoller. Zusätzlich wird eine sehr geringe Zeit vom Beginn der Entwicklung bis zur Marktreife (time-to-market) gefordert, die ohne aufwendige nachträgliche Korrekturen am Endprodukt in ihrer Einsatzumgebung auskommen müssen. Daraus resultieren die entsprechende Anforderungen hinsichtlich hoher Flexibilität bei gleichzeitig kostengünstiger Herstellung solcher Bauelemente. Beispiele für Steuerungssysteme unter Verwendung solcher Bauelemente in der Automobiltechnik umfassen Steuergeräte für Motor, Getriebe, ESP, Luftfederung, Klimatisierungsautomatik, Soundsystem, Einparkhilfen, Kombiinstrument und Datenbusse.

Die für spezielle Anwendungen gefertigten integrierten Schaltungen können dabei noch weiter unterteilt werden in vollständig durch den Anwender konfigurierbare Entwürfe und teilweise durch den Anwender konfigurierbare Entwürfe. Beim vollständig durch den Anwender konfigurierbaren Entwurf werden alle Entwurfsschritte entsprechend parametrisiert und optimiert, und es gibt keinerlei Einschränkungen für den Entwurf beziehungsweise die Konfiguration der späteren Verschaltung entsprechend der individuellen Kundenanforderungen. Bei diesen teilweise durch den Anwender konfigurierbaren Entwürfen, wie sie auch Gegenstand der vorliegenden Patentschrift sind, wird auf bereits vorgefertigte und vorverdrahtete Basisstrukturen zurückgegriffen, wobei diese dann durch den Anwender gemäß seiner Anforderungen konfigurierbar weiterhin untereinander und miteinander verschaltet werden können. Es ist offensichtlich, dass solche teilweise durch den Anwender konfigurierbaren Entwürfe hinsichtlich ihres Flächenbedarfs auf einem Chip, hinsichtlich der Leistungsaufnahme und der Herstellungskosten Vorteile aufweisen gegenüber den vollständig frei konfigurierbaren Entwürfen, deren Ausführung als integrierte Schaltung deutlich komplexer und damit unter anderem kostenintensiver ist.

Ein Beispiel für integrierte Schaltungen mit vorgefertigten Basisstrukturen nach dem Stand der Technik sind fest verdrahtete Hardwarelösungen, bei denen sich die Konfigurierbarkeit auf eine Parametrisierung mittels Registern beschränkt. Weitere Beispiele umfassen so genannte FPGAs (Field Programmable Gate Array, z.B. wie in WO03/105345) sowie Structured ASICs (Anwendungsspezifische ICs), die teilweise Basisstrukturen in Makrozellen zur Erhöhung der Effizienz hinsichtlich der benötigten Siliziumfläche des Chips, der Leistungsaufnahme und der Kosten aufweisen. Ebenfalls als Beispiel für die Verwendung vorgefertigter Basisstrukturen genannt werden können so genannte Streamimg Units, die jedoch in vielen Anwendungsfällen nicht die erforderliche Flexibilität aufweisen.

Nachteilig wirkt sich bei allen aufgeführten Beispielen von integrierten Schaltungen mit vorgefertigten Basisstrukturen nach dem Stand der Technik aus, dass diese zwar die Anforderungen bezüglich geringem Flächenbedarf auf einem Chip, geringer Leistungsaufnahme und geringen Kosten weitgehend erfüllen, die immer weiter steigenden Anforderungen nach Flexibilität in der Konfigurierbarkeit dieser kostengünstigen integrierten Schaltungen aber aus Sicht der aktuellen Anforderungen nicht ausreichend erfüllen.

Aufgabe der vorliegenden Erfindung ist es, einer Anordnung von Recheneinheiten, Auswahleinheiten und Steuereinheiten in einer Schaltungsarchitektur zur Verfügung zu stellen, die unter Beibehaltung der Vorteile von geringem Flächenbedarf auf einem Chip, geringer Leistungsaufnahme und geringen Kosten ein gegenüber dem Stand der Technik erhöhtes Maß an Flexibilität in der Konfigurierbarkeit aufweist und damit die oben genannten Nachteile nicht aufweist. Dabei soll diese Schaltungsarchitektur in einer Ausführungsform der Erfindung auch als integrierte Schaltung ausführbar sein.

Die Aufgabe wird gelöst durch eine Konfigurierbarkeit der Verschaltungen von Recheneinheiten und Steuereinheiten untereinander, die jeweils auf eine bestimmte Gruppe ausgewählter Funktionen und/oder Algorithmen, vorzugsweise aus den Anwendungsgebieten Management für Verbrennungsmotoren oder Fahrwerksteuerung, Video- und/oder Audioanwendungen, Graphikanwendungen und wissenschaftliche Berechnungen angepasst ist. Diese Anwendungen sind nur beispielhaft aufgezählt. Die Erfindung ist hierauf nicht beschränkt.

Die vorteilhafte Wirkung der Erfindung ergibt sich aus der erhöhten Flexibilität der Konfigurierbarkeit bei gleichzeitiger Beibehaltung der Effizienz hinsichtlich Flächenbedarf, Leistungsaufnahme und Herstellungskosten.

Weitere Vorteile können sich auch daraus ergeben, wenn sich die erhöhte Flexibilität der Anordnung nicht nur auf die Auswahl des in der integrierten Schaltung zu realisierenden Algorithmus bezieht, sondern trotz der für die erwünschte Effizienz notwendigen weitgehenden Vorfestlegung der Anordnung von und Verbindungen zwischen Recheneinheiten und Steuereinheiten auch die gleichzeitige Ausführung mehrerer und jeweils unterschiedlicher Algorithmen ermöglicht.

Noch weitere Vorteile können sich auch daraus ergeben, wenn die Größenordnung des Umfangs der konfigurierbaren Zusammenschaltung von Recheneinheiten und Steuereinheiten für jeden der mehreren unterschiedlichen ausgeführten Algorithmen individuell konfigurierbar ist, wodurch jedem der unterschiedlichen, beispielsweise gleichzeitig innerhalb der selben Anordnung ausgeführten Algorithmen durch nahezu beliebige individuelle Zusammenschaltung von Recheneinheiten die für die jeweilige Aufgabenstellung jeweils optimale Rechenleistung zur Verfügung gestellt werden kann, wobei die Konfiguration der Verschaltung gemäß einer Ausführungsform der Erfindung auch zur Laufzeit der Algorithmen erfolgen kann und damit dynamisch an unterschiedliche Aufgabenstellungen angepasst werden kann.

Ebenfalls noch weitere Vorteile können sich daraus ergeben, wenn die Recheneinheiten der erfindungsgemäßen Schaltungsanordnung dabei unterschiedlich, beispielsweise als Multiply / Accumulate-Einheiten und/oder Dividierer ausgeführt werden und wenn Teile der Schaltungsarchitektur wie beispielsweise Mikroprozessoren und Steuereinheiten wahlweise in die Schaltungsarchitektur mitintegriert oder als externe Anordnungen ausgeführt sind.

Die Erfindung wird nachfolgend anhand der in den Figuren der Zeichnungen dargestellten Ausführungsbeispiele näher erläutert, wobei gleiche Elemente mit gleichen Bezugszeichen versehen sind. Es zeigt
- Fig. 1: ein Blockschaltbild der Anordnung von Recheneinheiten und Auswahleinheiten,
- Fig. 2: eine Detailansicht der Anordnung von Recheneinheiten und Auswahleinheiten mit einer Steuereinheit,
- Fig. 3: ein Blockschaltbild der Anordnung von Recheneinheiten und Auswahleinheiten mit on-Chip Mikroprozessor

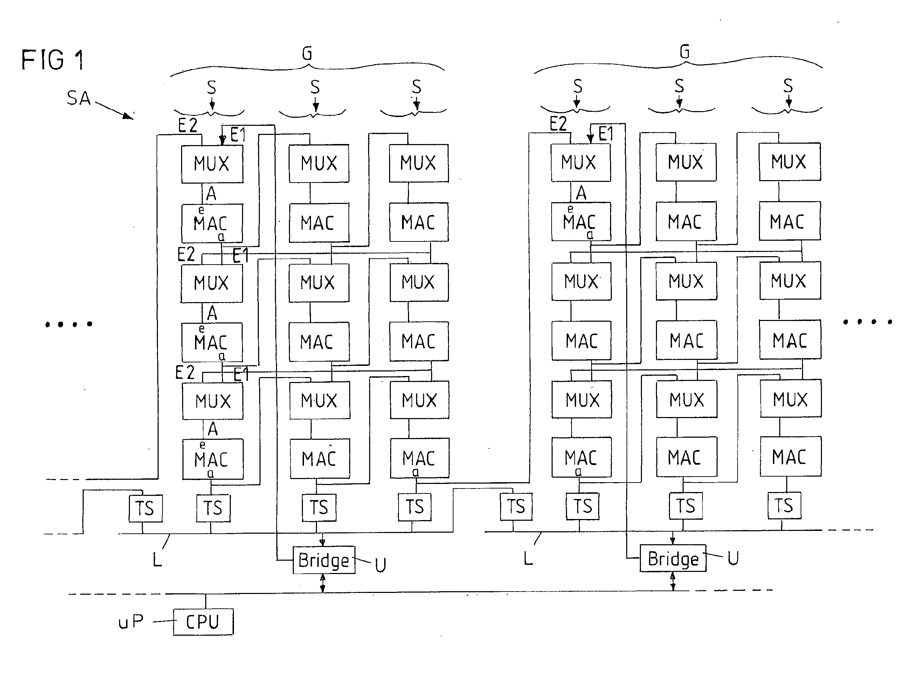

Die erfindungsgemäße Schaltungsarchitektur SA nach Fig.1 zeigt ein Blockschaltbild der Anordnung von Recheneinheiten und Auswahleinheiten der erfindungsgemäßen Anordnung SA. Die Anordnung umfasst dabei gemäß Fig. 1 eine Vielzahl von Gruppen G, die wiederum aus einer Vielzahl von Spalten S zusammengesetzt sind. Eine einzelne Spalte S setzt sich dabei zusammen aus einer Vielzahl von ersten Auswahleinheiten MUX und einer gleich großen oder ähnlichen Vielzahl von Recheneinheiten MAC, wobei die ersten Auswahleinheiten MUX und die Recheneinheiten MAC innerhalb einer Spalte S beginnend mit einer ersten Auswahleinheit MUX jeweils abwechselnd angeordnet und miteinender verbunden sind auf eine Weise, dass einer Recheneinheit MAC immer oder zumindest fast immer eine erste Auswahleinheit MUX vorgeschaltet ist, wobei dieser ersten Auswahleinheit MUX keine andere erste Auswahleinheit MUX unmittelbar vorgeschaltet ist, wodurch jeweils Pärchen bestehend aus je einer ersten Auswahleinheit MUX und einer Recheneinheit MAC gebildet werden. Innerhalb jeweils einer Gruppe G der Vielzahl von Gruppen G wird dabei jede der jeweils einer bestimmten Gruppe G zugehörigen Vielzahl von Spalten S aus der gleichen Anzahl von Auswahleinheiten MUX und Recheneinheiten MAC gebildet.

Jede der ersten Auswahleinheiten MUX weist dabei einen jeweils ersten Eingang E1 und einen zweiten Eingang E2 auf. Jede der Recheneinheiten MAC umfasst je einen Eingang e und je einen Ausgang a. Diese separaten Koeffizienteneingänge sind hier nicht gezeigt. Dabei sind die ersten Auswahleinheiten MUX vorzugsweise als Multiplexer mit jeweils mindestens zwei Eingängen ausgeführt. Weiterhin ist vorzugsweise mindestens ein Teil der Recheneinheiten MAC als Multiply / Accumulate-Einheiten ausgeführt und mindestens ein weiterer Teil der Recheneinheiten MAC ist als Dividierer ausgeführt.

Weiterhin umfasst Fig. 1 eine Vielzahl von zweiten Auswahleinheiten TS, eine Vielzahl von Sammelleitungen L, eine Vielzahl von vorzugsweise bidirektional ausgebildeten Umschalteinrichtungen U und einen Mikroprozessor uP. Dabei kann dieser Mikroprozessor uP gemäß verschiedener Ausführungsformen und Aufgabenstellungen als eine CPU, ein digitaler Signalprozessor oder eine State-Machine ausgeführt sein.

Gemäß Fig. 1 ist der Mikroprozessor uP mit jeder der Vielzahl von bidirektionalen Umschalteinrichtungen U verbunden, das heißt der Signalprozessor uP kann sowohl Signale von der Umschalteinrichtungen U entgegennehmen wie auch an diese leiten. Dabei ist jeder der Vielzahl von Gruppen G jeweils eine Umschalteinrichtung U zugeordnet. Diese Umschalteinrichtung U überträgt jeweils ein von dem Mikroprozessor uP empfangenes Signal an die jeweils erste der ersten Auswahleinheiten MUX in der jeweils ersten der Vielzahl von Spalten S in jeweils einer der Vielzahl von Gruppen G. Diese erste der ersten Auswahleinheiten MUX in der jeweils ersten der Vielzahl von Spalten S innerhalb einer Gruppe G ist gemäß Fig. 1 mit ihrem ersten Eingang E1 verbunden mit der Umschalteinrichtung U und nimmt auf diese Weise eine über die Umschalteinrichtung U zur Verfügung gestelltes Signal des Mikroprozessors uP entgegen.

Der zweite Eingang E2 dieser jeweils ersten der ersten Auswahleinheiten MUX in der jeweils ersten der Vielzahl von Spalten S innerhalb einer Gruppe G ist gemäß Fig. 1 verbunden mit dem Ausgang a der jeweils letzten der Vielzahl von Recheneinheiten MAC in der jeweils letzten der Vielzahl von Spalten S einer vorgelagerten Gruppe G der Vielzahl von Gruppen G, wodurch eine Vielzahl von Gruppen G innerhalb der Schaltungsarchitektur SA in Reihe miteinander verknüpft werden kann. Weiterhin ist gemäß Fig. 1 in jeder der Vielzahl der Spalten S jeder der jeweiligen Ausgänge A jeder der Vielzahl von ersten Auswahleinheiten MUX verbunden mit dem jeweiligen Eingang e der jeweils in der gleichen Spalte S nachgelagerten Recheneinheit MAC aus der Vielzahl von Recheneinheiten MAC. Diese Verbindung von Ausgang A der ersten Auswahleinheiten MUX mit Eingang e der in der gleichen Spalte S jeweils nachgelagerten Recheneinheit MAC setzt sich demnach gemäß Fig. 1 innerhalb einer jeden Spalte S aus der Vielzahl von Spalten S solange fort, bis das letzte aus jeweils einer ersten Auswahleinheit MUX und aus einer Recheneinheit MAC zusammengesetzte Pärchen innerhalb einer Spalte S erreicht wird.

Der Ausgang a jeder einzelnen dieser Recheneinheiten MAC aus der Vielzahl von Recheneinheiten MAC innerhalb einer Spalte S ist gemäß Fig. 1 jeweils wiederum verbunden mit dem Eingang E1 der in der jeweiligen Spalte S dieser Recheneinheit MAC jeweils nachgelagerten ersten Auswahleinheit MUX. Diese Verbindung von Ausgang a der Recheneinheiten MAC mit Eingang E1 der in der gleichen Spalte S jeweils nachgelagerten ersten Auswahleinheit MUX setzt sich demnach gemäß Fig. 1 innerhalb einer jeden Spalte S aus der Vielzahl von Spalten S solange fort, bis das letzte aus jeweils einer ersten Auswahleinheit MUX und aus einer Recheneinheit MAC zusammengesetzte Pärchen innerhalb einer Spalte S erreicht wird, wobei diese Recheneinheit MAC des jeweiligen letzten Pärchens einer jeden Spalte S mit ihrem Ausgang a jeweils mit dem Eingang einer zu dieser jeweiligen Spalte S zugehörigen und dieser Spaltes S nachgeschalteten zweiten Auswahleinheit TS der Vielzahl von zweiten Auswahleinheiten TS verbunden ist.

Weiterhin sind gemäß Fig. 1 jeweils innerhalb einer Gruppe G die zu einer der Spalten S dieser Gruppe G zugehörigen und diesen Spalten S nachgeschalteten zweiten Auswahleinheiten TS ausgangsseitig miteinander verbunden, wodurch für jede einzelne der Gruppen G aus der Vielzahl von Gruppen G eine Sammelleitung L ausgebildet wird. Diese Sammelleitung L einer jeden Gruppe G aus der Vielzahl von Gruppen G ist dabei über jeweils eine weitere der zweiten Auswahleinheiten TS aus der Vielzahl von zweiten Auswahleinheiten TS verbunden mit der Sammelleitung L der dieser Gruppe G jeweils vorgelagerten Gruppe G, wobei die Sammelleitung L der Gruppe G verbunden ist mit dem Ausgang dieser zweiten Auswahleinheit TS, deren Eingang wiederum verbunden ist mit der Sammelleitung L der dieser Gruppe G vorgelagerten Gruppe G. Auf diese Weise ist eine Verknüpfung von Recheneinheiten MAC einer Gruppe G zu einer vorgelagerten Gruppe G durchführbar. Dabei ist diese Vielzahl der zweiten Auswahleinheiten TS vorzugsweise als Tristatebuffer ausgeführt. Der Einfachheit halber wird in den Figuren der vorliegenden Erfindung auf die Darstellung der für Tristatebuffer benötigten Zuleitungen des Enablesignals verzichtet, dessen Funktion nach dem Stand der Technik als hinreichend bekannt vorausgesetzt werden kann. Weiterhin ist gemäß Fig. 1 die Sammelleitung L einer jeden der Vielzahl von Gruppen G verbunden mit einer der jeweiligen Gruppe G zugeordneten Umschalteinrichtung U, wodurch die auf der jeweiligen Sammelleitung L einer Gruppe G anliegenden Signale über die Umschalteinrichtung U dem Mikroprozessor uP zur Verfügung gestellt werden können.

Innerhalb einer jeden Gruppe G ist gemäß Fig. 1 weiterhin jede zweite und jede nachfolgende Auswahleinheit MUX der ersten Spalte S mit ihrem zweiten Eingang E2 mit einem Ausgang a einer Recheneinheit MAC in der letzten der Vielzahl von Spalten S dieser Gruppe G verbunden, wobei diese Recheneinheit MAC im Falle dieser zweiten der ersten Auswahleinheiten MUX in der ersten Spalte S dieser Gruppe G die erste Recheneinheit MAC in der letzten der Vielzahl von Spalten S dieser Gruppe G ist, diese Recheneinheit MAC im Falle der dritten der ersten Auswahleinheiten MUX in der ersten Spalte S dieser Gruppe G die zweite Recheneinheit MAC in der letzten der Vielzahl von Spalten S dieser Gruppe G ist usw. bis die letzte der zur ersten Spalte S der jeweiligen Gruppe G zugehörigen ersten Auswahleinheiten MUX und damit die vorletzte der der zur letzten Spalte S der jeweiligen Gruppe G zugehörigen Recheneinheiten MAC erreicht ist.

Weiterhin sind innerhalb einer jeden Gruppe G gemäß Fig. 1 die zweiten Eingänge E2 von allen der ersten Auswahleinheiten MUX der übrigen Spalten S (mit Ausnahme der ersten Spalte S) mit den Ausgängen a von Recheneinheiten MAC jeweils einer vorherigen Spalte S verbunden, wobei jeweils der zweite Eingang E2 der ersten der zu einer Spalte S gehörigen ersten Auswahleinheiten MUX mit dem Ausgang a der ersten zu einer vorherigen Spalte S gehörigen Recheneinheiten MAC verbunden ist, der zweite Eingang E2 der zweiten der zu einer Spalte S gehörigen ersten Auswahleinheiten MUX mit dem Ausgang a der zweiten zu einer vorherigen Spalte S gehörigen Recheneinheiten MAC verbunden ist usw. bis die letzte der zu einer Spalte S der jeweiligen Gruppe G gehörigen ersten Auswahleinheiten MUX und damit die letzte der zu einer vorherigen Spalte S der jeweiligen Gruppe G gehörigen Recheneinheiten MAC erreicht ist. Auf diese Weise ist insgesamt eine horizontale und/oder vertikale Verknüpfung der Recheneinheiten MAC innerhalb einer jeden der Gruppen G und/oder eine Verknüpfung von Recheneinheiten MAC einer Gruppe G zu einer vorgelagerten Gruppe G durchführbar.

Auf diese Weise kann durch entsprechendes Konfigurieren der vielfältigen im Entwurf der Schaltungsarchitektur SA vorgesehenen Verbindungen und Verknüpfungen zwischen den Recheneinheiten einer Gruppe (innerhalb einzelner und/oder zwischen den einzelnen Spalten S) und durch Konfigurieren der im Entwurf der Schaltungsarchitektur SA vorgesehenen Verknüpfungen zwischen Gruppen G das erwünschte hohe Maß an Flexibilität zur Ausführung gewünschter Algorithmen erreicht werden. Dabei können sowohl die Anzahl der in einer Spalte S angeordneten Recheneinheiten MAC wie auch deren Ausführungsform als Multiply/Accumulate-Einheiten oder Dividierer sowie die jeweilige Anzahl und Abfolge von diesen innerhalb der Spalten S für einzelne Spalten S einer Gruppe G auch unterschiedlich ausgeführt werden, wodurch sich die jeweils vorgegebene Grundstruktur der Schaltungsarchitektur SA in weiteren Ausführungsformen auch noch spezifischer auf die jeweiligen Anforderungen einer bestimmte Gruppe von auszuführenden Funktionen und Algorithmen anpassen lässt. Gleichzeitig wird trotz der hohen Flexibilität in der Konfigurierbarkeit das Grundprinzip von vorverdrahteten Baugruppen beibehalten und die erwünschte Effizienz hinsichtlich des Flächenbedarfs der Schaltungsarchitektur SA, geringer Leistungsaufnahme und kostengünstiger Fertigung einer entsprechenden, beispielsweise als integrierte Schaltung ausgeführten Schaltungsarchitektur SA bleibt wunschgemäß erhalten.

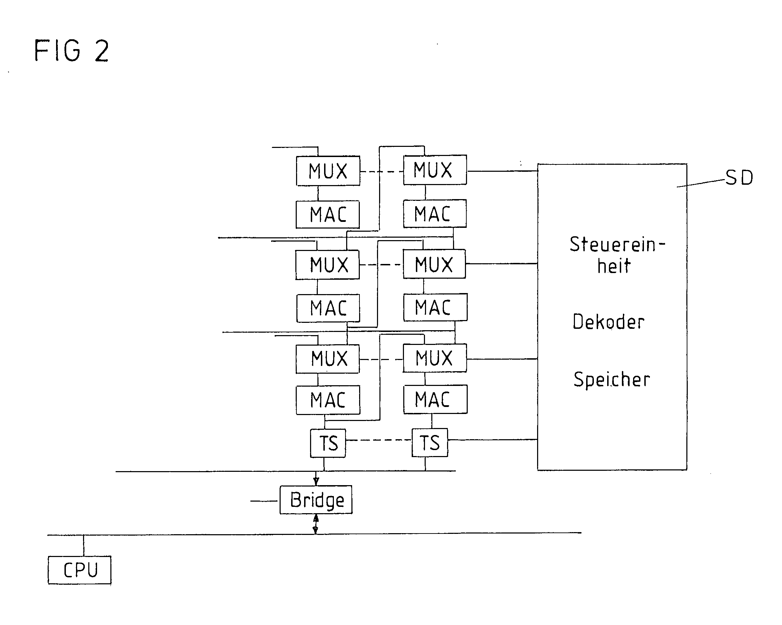

In der oben beschriebenen Ausführungsform gemäß Fig. 1 sind die ersten Auswahleinheiten MUX und die zweiten Auswahleinheiten TS z. B. maskenprogrammierbar ausgelegt. In einer weiteren Ausführungsform der erfindungsgemäßen Schaltungsarchitektur SA kann die Konfiguration dieser ersten Auswahleinheiten MUX und zweiten Auswahleinheiten TS alternativ dazu auch über eine Steuereinheit SD ausgeführt werden, wie in Fig. 2 dargestellt.

Fig. 2 zeigt dabei einen Teilbereich der Fig. 1 mit zwei Spalten S aus der Vielzahl von Spalten einer Gruppe G, wobei diese Spalten S die aus Fig. 1 bekannten ersten Auswahleinheiten MUX und Recheneinheiten MAC sowie die diesen Spalten S zugeordneten zweiten Auswahleinheiten TS umfassen. Weiterhin zeigt Fig. 2 die Umschalteinheit U gemäß Fig. 1 und den Anschluss des Mikroprozessors über diese Umschalteinheit an die Sammelleitung. Zusätzlich zu der aus Fig. 1 bekannten Darstellung ist in Fig. 2 eine Steuereinheit SD dargestellt. Diese Steuereinheit SD weist dabei Steuerleitungen zu allen ersten Auswahleinheiten MUX in allen Spalten S in allen Gruppen G und zu allen zweiten, den Gruppen G und den Spalten S zugeordneten zweiten Auswahleinheiten TS der erfindungsgemäßen Schaltungsarchitektur SA auf, wobei je nach Anzahl der ersten Auswahleinheiten MUX und der zweiten Auswahleinheiten TS auch für jede Gruppe G eine eigene Steuereinheit SD vorgesehen werden kann. Weiterhin kann/können diese Steuereinheit(en) SD gemäß alternativer Ausführungsformen der erfindungsgemäßen Schaltungsarchitektur SA als externe Schaltungsanordnungen angeordnet sein oder in einer zum Beispiel als integrierte Schaltung ausgeführten Schaltungsarchitektur integriert sein (off chip versus on chip).

In der erfindungsgemäßen Ausführungsform gemäß Fig. 2 sind die ersten und/oder die zweiten Auswahleinheiten MUX und TS so ausgeführt, dass diese über Decoder und Speicher steuerbar sind. Dies ermöglicht es, dass die gewünschte Verschaltung und Verknüpfung der Recheneinheiten MAC innerhalb der Spalten S (vertikale Verknüpfungen), innerhalb der Gruppen G (horizontale Verknüpfungen) und über mehrere Gruppen G hinweg zur Laufzeit des jeweils abzuarbeitenden Algorithmus entsprechend den Anforderungen konfiguriert werden können. In einer weiteren Ausführungsform der erfindungsgemäßen Schaltungsarchitektur SA können die ersten Auswahleinheiten MUX und/oder die zweiten Auswahleinheiten TS alternativ zur Ausführungsform gemäß Fig. 2 auch über Register steuerbar sein.

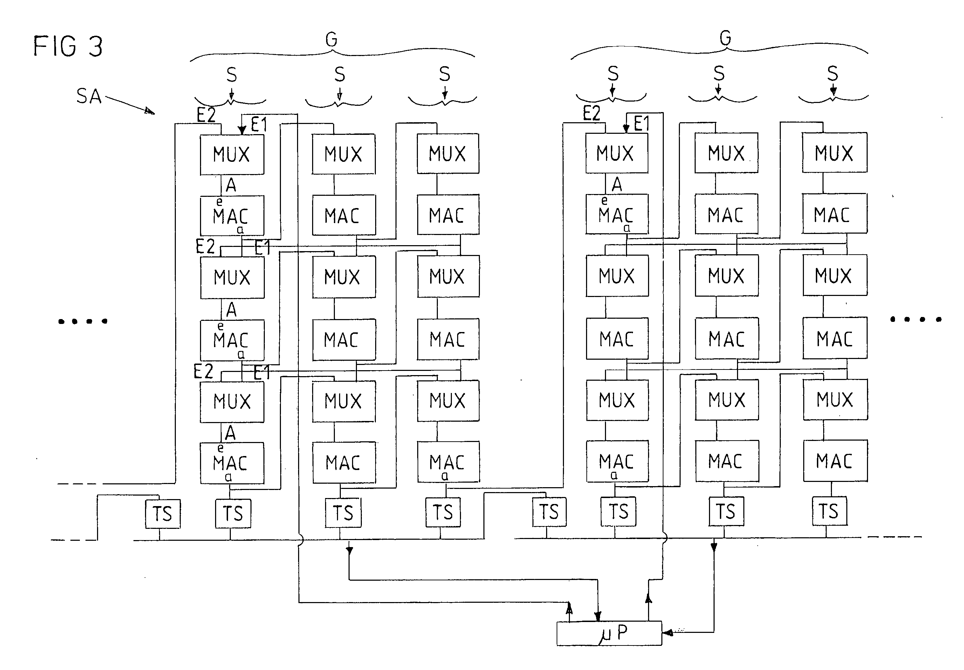

Wie bereits weiter oben beschrieben, kann der mit den jeweiligen Eingängen E1 der jeweils ersten der ersten Auswahleinheiten MUX in der jeweils ersten Spalte S einer Gruppe G verbundene Mikroprozessor uP gemäß verschiedener Ausführungsformen und Aufgabenstellungen als eine CPU, ein digitaler Signalprozessor oder eine State-Machine ausgeführt sein. Dabei ist dieser Mikroprozessor uP gemäß den Figuren 1 und 2 als eine zur Schaltungsarchitektur SA extern angeordnete Baugruppe ausgeführt. Dies ermöglicht die oben genannte Flexibilität hinsichtlich der Ausführungsform des Mikroprozessors beispielsweise als CPU, digitaler Signalprozessor oder State-Machine in Abhängigkeit von der erforderlichen Rechenleistung gemäß der gewünschten auszuführenden Funktionen und Algorithmen für den jeweiligen Anwendungsfall, während die erfindungsgemäße Schaltungsanordnung SA, zusammengesetzt aus ersten Auswahleinheiten MUX, zweiten Auswahleinheiten TS, Recheneinheiten MAC und Umschalteinrichtungen U erfindungsgemäß als flexibel konfigurierbare und kostengünstig zu produzierende integrierte Schaltung ausgeführt sein kann. In einer weiteren Ausführungsform der Erfindung kann dieser Mikroprozessor auch als Mikroprozessorstruktur in die erfindungsgemäße Schaltungsanordnung SA integriert sein. Ein Beispiel hierzu ist aus dem Blockschaltbild gemäß Fig. 3 zu ersehen.

Fig. 3 umfasst dabei wiederum die aus Fig. 1 bekannte Anordnung von ersten Auswahleinheiten MUX, zweiten Auswahleinheiten TS und Recheneinheiten MAC zur Bildung der Spalten S und Gruppen G der Schaltungsarchitektur SA. Da gemäß Fig. 3 der Mikroprozessor uP Bestandteil der beispielsweise als integrierte Schaltung ausgeführten Schaltungsarchitektur ist, kann auf die Umschalteinrichtungen U verzichtet werden, da die Anzahl der andernfalls von der Schaltungsarchitektur zum Anschluss des Mikroprozessors uP nach außen zu führenden Anschlussleitungen keine Rolle spielt (bei einem extern angeordneten Mikroprozessor uP gemäß Fig. 1 wird die Anzahl der benötigten Anschlussleitungen für den Mikroprozessor, beispielsweise am Gehäuse einer als integrierte Schaltung ausgeführten Schaltungsarchitektur durch die Umschalteinheiten U halbiert).

Gemäß der Ausführungsform nach Fig. 3 ist der Mikroprozessor uP jeweils direkt mit den Eingängen E1 der jeweils ersten der ersten Auswahleinheiten MUX in der jeweils ersten Spalte S einer Gruppe G verbundenen und gleichzeitig ist die jeweilige Sammelleitung L jeder der Vielzahl von Gruppen G ebenfalls mit dem in die Schaltungsarchitektur integrierten Mikroprozessor uP verbunden. Auf diese Weise kann die Größe der gesamten Anordnung der erfindungsgemäßen Schaltungsanordnung weiter reduziert werden, wenn bereits beim Herstellungsprozess der Schaltungsanordnung die für die jeweilige Aufgabenstellung benötigte Ausführungsform des Mikroprozessors uP festgelegt werden kann.

Die erfindungsgemäßen Ausführungsformen der Schaltungsarchitektur SA stellen die gewünschte Effizienz hinsichtlich benötigter Siliziumfläche bei Ausführung als integrierte Schaltung, hinsichtlich geringer Leistungsaufnahme und kostengünstiger Herstellung zur Verfügung. Gleichzeitig wird ein wunschgemäß hohes Maß an Flexibilität in der Konfigurierbarkeit erreicht. Diese Flexibilität wird insbesondere dadurch erreicht, in dem die im Entwurf der Schaltungsarchitektur SA vorgesehenen Verbindungen und Verknüpfungen zwischen den Recheneinheiten MAC einer Gruppe G und hier wiederum innerhalb einzelner und/oder zwischen den einzelnen Spalten S einer Vielzahl von Spalten in einer Gruppe G entsprechend der jeweiligen Anforderungen frei konfigurierbar sind.

Dabei können sowohl die Anzahl der in einer Spalte S angeordneten Recheneinheiten MAC, wie auch deren Ausführungsform als Multiply/Accumulate-Einheiten oder Dividierer sowie die jeweilige Anzahl und Abfolge von diesen innerhalb der Spalten S für einzelne Spalten S einer Gruppe G auch jeweils unterschiedlich ausgeführt werden, wodurch sich die jeweils vorgegebene Grundstruktur der Schaltungsarchitektur SA in weiteren Ausführungsformen auch spezifisch auf die jeweiligen Anforderungen einer bestimmten Gruppe von auszuführenden Funktionen und Algorithmen anpassen lässt. Weiterhin können auch die einzelnen Gruppen G innerhalb einer festgelegten Schaltungsarchitektur SA in jeweils beliebiger Anzahl so untereinander verknüpft werden, dass sie sich zur gleichzeitigen (parallelen) Ausführung mehrerer unterschiedlich komplexer und rechenintensiver Algorithmen eignen.

In den Ausführungsformen der erfindungsgemäßen Schaltungsanordnung, in denen die Konfiguration der Verknüpfung der ersten und zweiten Auswahleinheiten entweder über Dekoder und Speicher oder über Register einer Steuereinheit SD erfolgt, kann darüber hinaus die Festlegung der Verknüpfung von Recheneinheiten MAC, von Spalten S und Gruppen G auch zur Laufzeit der jeweiligen Algorithmen dynamisch erfolgen und ist nicht auf eine einmal, beispielsweise durch Maskenprogrammierung festgelegt Verknüpfung eingeschränkt. Diese Steuereinheit SD kann dabei wiederum als eine zur Schaltungsarchitektur externe Anordnung ausgeführt sein oder bei Ausführung als integrierte Schaltung in diese mitintegriert werden. Durch die optionale Integration des Mikroprozessors uP in die Schaltungsarchitektur, beispielsweise als Mikroprozessorstruktur in einer integrierten Schaltung, wird eine weitere Reduzierung des Flächenbedarfs der Anordnung ermöglicht. Alternativ dazu kann der Mikroprozessor uP als extern anschließbare Anordnung ausgeführt sein und so hinsichtlich seiner Ausführungsform der jeweiligen Aufgabenstellung optimal angepasst werden.

### Bezugszeichenliste:

- A: Ausgang der ersten Auswahleinheit
- a: Ausgang der Recheneinheit
- e: Eingang der Recheneinheit
- E1: erster Eingang der ersten Auswahleinheit
- E2: zweiter Eingang der ersten Auswahleinheit
- G: Gruppe
- MAC: Recheneinheit
- MUX: erste Auswahleinheit
- S: Spalte
- SA: Schaltungsarchitektur
- TS: zweite Auswahleinheit
- U: Umschalteinrichtung
- uP: Mikroprozessor

## Patentansprüche

1. Schaltungsarchitektur für eine integrierte Schaltung mit einem Mikroprozessor (uP) und folgenden Merkmalen:
- mindestens eine Gruppe (G) mit mehreren jeweils ins Spalten (S) angeordneten Recheneinheiten (MAC),
- in den Spalten (S) ist einem Eingang (e) einer Recheneinheit (MAC) jeweils ein einziger Multiplexer (MUX) vorgeschaltet, wobei diesem Multiplexer (MUX) kein anderer Multiplexer (MUX) unmittelbar vorgeschaltet ist,
- jeder Multiplexer (MUX) weist mindestens zwei Eingänge (E1, E2) und einen Ausgang (A) auf, wobei der Eingang (e) einer Recheneinheit (MAC) mit einem einzigen Ausgang (A) eines einzigen Multiplexers (MUX) verbunden ist,
- der erste Eingang (E1) der Multiplexer (MUX) in einer Gruppe (G) ist mit dem Ausgang (a) einer vorherigen Recheneinheit (MAC) verbunden, wobei der erste Multiplexer (MUX) einer ersten Spalte (S) einer Gruppe (G) mit seinem ersten Eingang (E1) an den Mikroprozessor (uP) gekoppelt ist,
- der zweite Eingang (E2) jedes ersten Multiplexers (MUX) der ersten Spalte (S) einer Gruppe (G) ist mit dem Ausgang (a) einer letzten Recheneinheit (MAC) einer unmittelbar vorherigen Gruppe (G) verbunden, wobei jeder nachfolgende Multiplexer (MUX) der ersten Spalte (S) mit seinem zweiten Eingang (E2) mit einem Ausgang (a) einer Recheneinheit (MAC) der letzten Spalte (S) dieser Gruppe (G) verbunden ist, und wobei die zweiten Eingänge (E2) der übrigen Multiplexer (MUX) einer Spalte (S) mit den Ausgängen (a) der Recheneinheit (MAC) jeweils einer vorherigen Spalte (S) verbunden sind,
- zweite Auswahleinheiten (TS) sind jeweils einer Spalte (S) von Recheneinheiten (MAC) nachgeschaltet,
- die zweiten Auswahleinheiten (TS) einer Gruppe (G) sind ausgangsseitig an jeweils eine Sammelleitung (L) geschaltet,
- der Mikroprozessor (uP) ist an die Sammelleitung (L) gekoppelt.

2. Schaltungsarchitektur nach Anspruch 1,
**dadurch gekennzeichnet, dass** der Mikroprozessor (uP) eine CPU, ein digitaler Signalprozessor (DSP) oder eine State-Machine (SM) ist.

3. Schaltungsarchitektur nach Anspruch 1 oder 2,
**dadurch gekennzeichnet, dass** die Multiplexer und/oder die zweiten Auswahleinheiten (MUX, TS) maskenprogrammiert ansteuerbar sind.

4. Schaltungsarchitektur nach einem der Ansprüche 1 bis 3,
**dadurch gekennzeichnet, dass** die Multiplexer und/oder die zweiten Auswahleinheiten (TS) über Decoder und Speicher steuerbar sind.

5. Schaltungsarchitektur nach einem der Ansprüche 1 bis 4,
**dadurch gekennzeichnet, dass** die Multiplexer und/oder die zweiten Auswahleinheiten (TS) über Register steuerbar sind.

6. Schaltungsarchitektur nach einem der Ansprüche 1 bis 5,
**dadurch gekennzeichnet, dass** die zweiten Auswahleinheiten (TS) Tristatebuffer sind.

7. Schaltungsarchitektur nach einem der Ansprüche 1 bis 6,
**dadurch gekennzeichnet, dass** mindestens ein Teil der Recheneinheiten (MAC) Multiply/Accumulate-Einheiten sind.

8. Schaltungsarchitektur nach einem der Ansprüche 1 bis 7,
**dadurch gekennzeichnet, dass** mindestens ein Teil der Recheneinheiten (MAC) Dividierer sind.

9. Schaltungsarchitektur nach einem der Ansprüche 1 bis 8,
**dadurch gekennzeichnet, dass** die Umschalteinrichtung (U) bidirektional derart gestaltet ist, dass einerseits vom Mikroprozessor (uP) Signale an die Multiplexer (MUX) einer ersten Spalte (S) einer Gruppe (G) und andererseits Signale von der Sammelleitung (L) an den Mikroprozessor (uP) leitbar sind.

10. Schaltungsarchitektur nach einem der Ansprüche 1 bis 9,
**dadurch gekennzeichnet, dass** diese in einem integrierten Schaltkreis implementiert ist.

11. Schaltungsarchitektur nach einem der Ansprüche 1 bis 10,
**dadurch gekennzeichnet, dass** eine Vielzahl von Gruppen (G) vorgesehen ist.

12. Schaltungsarchitektur nach einem der Ansprüche 1 bis 11,
**dadurch gekennzeichnet, dass** zwischen die Sammelleitung (L) und den Mikroprozessor (uP) eine Umschalteinrichtung (U) geschaltet ist.

13. Verwendung der Schaltungsarchitektur nach einem der Ansprüche 1 bis 12 in einer Steuereinheit für ein Kraftfahrzeuges, für Video und/oder Audioanwendungen oder wissenschaftlichen Berechnungen.

## Claims

1. Circuit architecture for an integrated circuit of a microprocessor (µP) and following features:
- at least one group (G) with a plurality of computing units (MAC) respectively arranged in columns (S),
- in the columns (6) a respective single multiplexer (MUX) is connected upstream of an input (e) of a computing unit (NAC), wherein no other multiplexer (MUX) is directly connected upstream of this multiplexer (MUX),
- each multiplexer (MUX) has at least two inputs (E1, E2) and an output (A), wherein the input (e) of a computing unit (MAC) is connected with a single output (A) of a single multiplexer (MUX),
- the first input (E1) of the multiplexer (MUX) in a group (G) is connected with the output (a) of a preceding computing unit (MAC), wherein the first multiplexer (MUX) of a first column (S) of a group (G) is coupled by its first input (E1) to the microprocessor (µP),
- the second input (E2) of each first multiplexer (MUX) of the first column (S) of a group (G) is connected with the output (a) of a last computing unit (MAC) of a directly preceding group (G), wherein each succeeding multiplexer (MUX) of the first column (S) is connected by its second input (E2) with an output (a) of a computing unit (MAC) of the last column (S) of this group (G) and wherein the second inputs (E2) of the remaining multiplexers (MUX) of a column (S) are connected with the outputs (a) of the computing unit (MAC) of a respective preceding column (S),
- second selecting units (TS) are respectively connected downstream of a column (S) of computing units (MAC),
- the second selecting units (TS) of a group (G) are connected at the output side with a respective collecting line (L) and
- the microprocessor (µP) is coupled to the collecting line (L).

2. Circuit architecture according to claim 1, **characterised in that** the microprocessor (µP) is a CPU, a digital signal processor (DSP) or a state machine (SM).

3. Circuit architecture according to claim 1 or 2, **characterised in that** the multiplexers and/or the second selecting units (MUX, TS) are activatable by way of mask programming.

4. Circuit architecture according to any one of claims 1 to 3, **characterised in that** the multiplexers and/or the second selecting units (TS) are controllable by way of decoders and memories.

5. Circuit architecture according to any one of claims 1 to 4, **characterised in that** the multiplexers and/or the second selecting units (TS) are controllable by way of registers.

6. Circuit architecture according to any one of claims 1 to 5, **characterised in that** the second selecting units (TS) are tri-state buffers.

7. Circuit architecture according to any one of claims 1 to 6, **characterised in that** multiply/accumulate units form at least a part of the computer units (MAC).

8. Circuit architecture according to any one of claims 1 to 7, **characterised in that** dividers form at least a part of the computing units (MAC).

9. Circuit architecture according to any one of claims 1 to 8, **characterised in that** the switchover device (U) is designed to be bidirectional in such a way that on the one hand signals can be conducted from the microprocessor (µP) to the multiplexers (MUX) of a first column (S) of a group (G) and on the other hand signals can be conducted from the collecting line (L) to the microprocessor (µP).

10. Circuit architecture according to any one of claims 1 to 9, **characterised in that** this is implemented in an integrated circuit.

11. Circuit architecture according to any one of claims 1 to 10, **characterised in that** a plurality of groups (G) is provided.

12. Circuit architecture according to any one of claims 1 to 11, **characterised in that** a switchover device (U) is connected between the collecting line (L) and the microprocessor (µP).

13. Use of the circuit architecture according to any one of claims 1 to 12 in a control unit for a motor vehicle, for video and/or audio applications or scientific calculations.

## Revendications

1. Architecture de circuit pour un circuit intégré avec un microprocesseur (µP) et les caractéristiques suivantes :
- au moins un groupe (G) avec plusieurs unités de calcul (MAC) disposées respectivement en colonnes (S),
- dans les colonnes (S), un seul multiplexeur (MUX) est respectivement connecté avant une entrée (e) d'une unité de commande (MAC), aucun autre multiplexeur (MUX) n'étant connecté immédiatement avant ce multiplexeur (MUX),
- chaque multiplexeur (MUX) présente au moins deux entrées (E1, E2) et une sortie (A), l'entrée (e) d'une unité de calcul (MAC) étant reliée à une seule sortie (A) d'un seul multiplexeur (MUX),
- la première entrée (E1) des multiplexeurs (MUX) dans un groupe (G) est reliée à la sortie (a) d'une unité de calcul précédente (MAC), le premier multiplexeur (MUX) d'une première colonne (S) d'un groupe (G) étant couplé par sa première entrée (E1) au microprocesseur (µP),
- la deuxième entrée (E2) de chaque premier multiplexeur (MUX) de la première colonne (S) d'un groupe (G) est reliée à la sortie (a) d'une dernière unité de calcul (MAC) d'un groupe (G) immédiatement précédent, chaque multiplexeur (MUX) suivant de la première colonne (S) étant relié par sa deuxième entrée (E2) à une sortie (a) d'une unité de calcul (MAC) de la dernière colonne (S) de ce groupe (G), et les deuxièmes entrées (E2) des autres multiplexeurs (MUX) d'une colonne (S) étant reliées aux sorties (a) de l'unité de calcul (MAC) d'une colonne respectivement précédente (S),
- des deuxièmes unités de sélection (TS) sont connectées respectivement après une colonne (S) d'unités de calcul (MAC),
- les deuxièmes unités de sélection (TS) d'un groupe (G) sont respectivement connectées côté sortie à une ligne collectrice (L),
- le microprocesseur (µP) est couplé à la ligne collectrice (L).

2. Architecture de circuit selon la revendication 1, **caractérisée en ce que** le microprocesseur (µP) est une unité centrale (CPU), un processeur numérique de signaux (DSP) ou un automate fini (SM).

3. Architecture de circuit selon la revendication 1 ou 2, **caractérisée en ce que** les multiplexeurs et/ou les deuxièmes unités de sélection (MUX, TS) peuvent être commandés par programme masqué.

4. Architecture de circuit selon l'une quelconque des revendications 1 à 3, **caractérisée en ce que** les multiplexeurs et/ou les deuxièmes unités de sélection (TS) peuvent être commandés par décodeur et mémoire.

5. Architecture de circuit selon l'une quelconque des revendications 1 à 4, **caractérisée en ce que** les multiplexeurs et/ou les deuxièmes unités de sélection (TS) peuvent être commandés par des registres.

6. Architecture de circuit selon l'une quelconque des revendications 1 à 5, **caractérisée en ce que** les deuxièmes unités de sélection (TS) sont des tampons à trois états.

7. Architecture de circuit selon l'une quelconque des revendications 1 à 6, **caractérisée en ce qu'**au moins une partie des unités de calcul (MAC) sont des unités de multiplication-accumulation.

8. Architecture de circuit selon l'une quelconque des revendications 1 à 7, **caractérisée en ce qu'**au moins une partie des unités de calcul (MAC) sont des diviseurs.

9. Architecture de circuit selon l'une quelconque des revendications 1 à 8, **caractérisée en ce que** le dispositif de commutation (U) a une configuration bidirectionnelle, de telle manière que d'une part des signaux puissent être transmis du microprocesseur (µP) aux multiplexeurs (MUX) d'une première colonne (S) d'un groupe (G) et que d'autre part des signaux puissent être transmis de la ligne collectrice (L) au microprocesseur (µP).

10. Architecture de circuit selon l'une quelconque des revendications 1 à 9, **caractérisée en ce que** celle-ci est mise en oeuvre dans un circuit intégré.

11. Architecture de circuit selon l'une quelconque des revendications 1 à 10, **caractérisée en ce qu'**il est prévu une multiplicité de groupes (G).

12. Architecture de circuit selon l'une quelconque des revendications 1 à 11, **caractérisée en ce qu'**un dispositif de commutation (U) est connecté entre la ligne collectrice (L) et le microprocesseur (µP).

13. Utilisation de l'architecture de circuit selon l'une quelconque des revendications 1 à 12 dans une unité de commande pour un véhicule automobile, pour des applications vidéo et/ou audio ou des calculs scientifiques.
